# DEMANDE DE BREVET EUROPEEN

(11) **EP 4 759 503 A1**
(43) Date de publication de la demande: **17.06.2026**
(21) Numéro de dépôt: 25221886.2
(22) Date de dépôt: 09.12.2025
(51) Int. Cl.: B29C 33/38, B29C 33/42, G03F 7/00, B82Y 40/00, B29C 33/56

(54) **PROCÉDÉ DE FABRICATION D'UN MOULE D'IMPRESSION**

(30) Priorité: 11.12.2024 FR 2413840
(71) Demandeur: Commissariat à l'Energie Atomique et aux Energies Alternatives, 75015 Paris (FR)
(72) Inventeur: RECHE, Jérôme, 38054 GRENOBLE CEDEX 09 (FR); ARGOUD, Maxime, 38054 GRENOBLE CEDEX 09 (FR)
(74) Mandataire: Lebkiri, Alexandre

(57) **Abrégé**

L'invention concerne un procédé de fabrication d'un moule d'impression (40), comprenant les étapes suivantes :
- fournir un moule maître (10) ayant une surface structurée dotée d'un caractère antiadhésif, la surface structurée présentant une pluralité de motifs (20) ;
- modifier une portion (100) seulement de la surface structurée de façon à faire perdre à ladite portion son caractère antiadhésif, ladite portion (100) comprenant au moins un des motifs (20) ;
- former un support sur la surface structurée, le support comprenant une couche d'impression structurée par les motifs (20) ;
- séparer (S4) le support du moule maître (10) pour obtenir le moule d'impression (40), une partie (311) de la couche d'impression restant fixée à la portion modifiée (100) de la surface structurée.

## Description

### DOMAINE TECHNIQUE DE L'INVENTION

La présente invention se rapporte au domaine de la lithographie par impression. L'invention concerne plus particulièrement un procédé de fabrication d'un moule d'impression communément appelé moule intermédiaire ou encore moule de travail, à partir d'un moule maître.

### ARRIERE-PLAN TECHNOLOGIQUE DE L'INVENTION

Parmi les techniques de lithographie mises en œuvre dans l'industrie de la microélectronique pour la fabrication de circuits intégrés, la technique de la nano-impression suscite un intérêt croissant. Cette technique repose sur l'impression d'un matériau déformable, typiquement une résine, avec un moule. Le moule comporte des motifs qui sont transférés dans la résine lors de l'impression et dont les dimensions sont généralement comprises entre quelques nanomètres et plusieurs centaines de micromètres.

Il existe deux types de moules d'impression : les moules dits « rigides » et les moules dits « souples ».

Un avantage des moules rigides, par exemple basés sur des substrats en silicium, est leur résistance mécanique, les rendant réutilisables un grand nombre de fois.

Un avantage des moules souples, généralement à base de matériaux polymères, réside dans leur capacité à pouvoir se déformer et ainsi réaliser un contact conforme sur toute la surface à imprimer, ce qui permet d'obtenir une distribution plus uniforme de la pression appliquée par le moule. Pour cette raison, les moules souples sont généralement utilisés pour imprimer des couches de grandes superficie, par exemple sur des substrats dont le diamètre est supérieur à 100 mm. En outre, leur souplesse permet de réduire les risques de casse en présence de poussières entre la surface à imprimer et le moule. Le démoulage d'un moule souple pressé contre une couche de résine de lithographie est facilité, car il peut être réalisé par pelage.

Des moules de travail, souples ou rigides, peuvent être réalisés à partir d'un moule primaire, communément appelé moule maître (de l'anglais « master mold »). Une face de ce moule maître présente des motifs formant une image en négatif du relief à conférer aux moules de travail. Un même moule maître permet alors de fabriquer plusieurs moules de travail, ce qui tend à diminuer le coût de fabrication de ces moules.

Le moule maître est généralement réalisé grâce aux technologies de fabrication de l'industrie microélectronique (photolithographie, gravure...) à partir d'un substrat en matériau semiconducteur, par exemple en silicium.

Le moule de travail est généralement obtenu à partir du moule maître en déposant sur le moule maître un matériau polymère à l'état liquide ou semi-liquide appelé résine. Ce matériau polymère est destiné à former une partie du moule de travail, celle présentant les motifs. Pour former un moule souple, un film souple en matériau polymère peut ensuite être laminé sur l'empilement que forment le moule maître et la couche de résine. En variante, pour former un moule plus dur, une poignée rigide peut être appliquée par-dessus le matériau polymère. Puis, l'ensemble est exposé à un rayonnement électromagnétique (généralement un rayonnement ultraviolet) et/ou à un traitement thermique auquel la résine est sensible. La résine est ainsi durcie. Elle présente une adhésion préférentielle sur le film souple ou la poignée rigide plutôt que sur le moule maître, ce qui permet le démoulage au niveau du moule maître. Le film souple ou la poignée rigide et la couche de résine durcie forment ensemble le moule de travail. Le moule de travail présente, dans la couche de résine durcie, des motifs de polarité inversée à ceux présents sur le moule maître (un motif en saillie devient un motif en creux, et inversement).

La surface structurée (c'est-à-dire présentant les motifs) du moule maître peut être recouverte d'une couche antiadhésive afin de faciliter le démoulage du moule de travail.

Un inconvénient de ce procédé de fabrication est que les moules de travail fabriqués à partir d'un même moule maître sont tous identiques, ce qui obligent donc à multiplier les moules maître.

### RESUME DE L'INVENTION

Il existe donc un besoin d'un procédé de fabrication de moule d'impression qui puisse être adapté pour pouvoir fabriquer différents moules à partir d'un même moule maître.

Selon un aspect de l'invention, on tend à satisfaire ce besoin en prévoyant un procédé de fabrication d'un moule d'impression, comprenant les étapes suivantes :
- fournir un moule maître ayant une surface structurée dotée d'un caractère antiadhésif, la surface structurée présentant une pluralité de motifs ;
- modifier une portion seulement de la surface structurée de façon à faire perdre à ladite portion son caractère antiadhésif, ladite portion comprenant au moins un des motifs ;
- former un support sur la surface structurée, le support comprenant une couche d'impression structurée par les motifs ;
- séparer le support du moule maître pour obtenir le moule d'impression, une partie de la couche d'impression restant fixée à la portion modifiée de la surface structurée.

Dans un mode de mise en œuvre préférentiel du procédé de fabrication, le moule maître comprend un substrat et une couche antiadhésive disposée sur le substrat et la surface structurée dotée du caractère antiadhésif appartient à la couche antiadhésive.

Selon un premier développement de ce mode de mise en œuvre préférentiel, la portion de la surface structurée est modifiée en dégradant une portion de la couche antiadhésive.

La portion de la couche antiadhésive est de préférence dégradée par une pointe ou par exposition à un faisceau d'électrons, un laser ou une solution chimique.

Selon un deuxième développement, la portion de la surface structurée est modifiée en retirant entièrement une portion de la couche antiadhésive.

La formation du support sur la surface structurée peut comprendre les sous-étapes suivantes :
- déposer une couche de résine durcissable sur la surface structurée ;
- mettre en contact une couche de support avec la couche de résine durcissable ; et
- durcir la résine ;
la couche d'impression du support étant formée par la couche de résine durcie.

Alternativement, la formation du support sur la surface structurée peut comprendre les sous-étapes suivantes :
- déposer une couche de résine durcissable sur une couche de support ;
- presser la couche de résine durcissable contre la surface structurée ; et
- durcir la résine ;
la couche d'impression du support étant formée par la couche de résine durcie.

La couche de support peut être un film souple ou un substrat rigide.

Le procédé peut comprendre, après l'étape de séparation du support, une étape de restauration de la surface structurée dotée du caractère antiadhésif.

### BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- les figures 1A à 1F représentent schématiquement un mode de mise en œuvre préférentiel d'un procédé de fabrication de moule d'impression selon l'invention ; et
- les figures 2A à 2C représentent schématiquement un procédé de lithographie utilisant le moule d'impression fabriqué.

Pour plus de clarté, les éléments identiques ou similaires sont repérés par des signes de référence identiques sur l'ensemble des figures.

### DESCRIPTION DETAILLEE

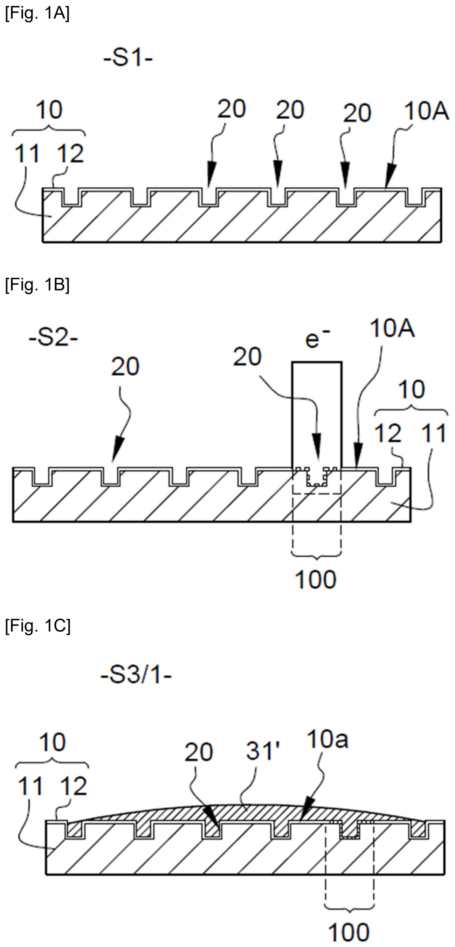

Les figures 1A à 1F illustrent des étapes S1 à S4 d'un procédé de fabrication de moule d'impression selon un mode de mise en œuvre préférentiel de l'invention. Le moule d'impression, aussi appelé moule de travail ou moule intermédiaire, peut être utilisé dans un procédé de lithographie par impression dans le cadre de la fabrication de dispositifs microélectroniques. Ainsi, l'expression « moule de lithographie par impression » peut être également employée pour désigner le moule d'impression.

Dans ce mode de mise en œuvre préférentiel, le moule d'impression est souple. D'une manière générale, le caractère souple du moule d'impression (ainsi que du support souple et du film souple décrits ci-après) fait référence, alternativement ou cumulativement :
- à sa capacité de déformation élastique afin d'épouser une surface à imprimer non plane lors des impressions, réalisant ainsi un contact conforme sur toute la surface à imprimer ;
- à sa capacité de déformation élastique lors d'au moins une étape d'utilisation du moule, telle qu'un laminage sur une surface à imprimer ou un pelage ;
- au module de Young inférieur à 1 GPa de son matériau ou de ses matériaux ;
- à sa capacité de déformation en flexion avec un rayon de courbure inférieur ou égal à 1 m, de préférence inférieur ou égal à 5 cm.

En référence à la figure 1A, le procédé comprend tout d'abord une étape S1 de fourniture d'un moule maître 10, ou modèle maître (« master template » en anglais), à partir duquel le moule d'impression va être fabriqué. Le moule maître 10 présente une surface structurée 10A, c'est-à-dire une surface présentant des motifs 20. Les motifs 20 du moule maître 10 sont des motifs topographiques, autrement dit des motifs en creux ou en saillie. Ici, les motifs 20 considérés sont des motifs en creux. Ils peuvent être des trous, par exemple en forme de cylindre droit, et/ou de lignes.

Le moule maître 10 peut être fabriqué à partir d'un substrat 11, par exemple en silicium, grâce aux technologies de fabrication utilisées dans l'industrie microélectronique, typiquement par photolithographie et gravure.

Les motifs 20 peuvent présenter des dimensions comprises entre 1 nm et 500 µm, de préférence comprises entre 50 nm et 1 µm. En particulier, la hauteur des motifs, mesurée perpendiculairement aux faces principales du substrat 11, peut être comprise entre 50 nm et 500 nm. Etant donné que le moule d'impression présentera des motifs de mêmes dimensions que les motifs 20 du moule maître, mais selon une polarité (image en négatif), le moule d'impression fabriqué pourra être qualifié de moule de nano-impression (dans la mesure où il permet d'imprimer des motifs de dimensions nanométriques).

La surface structurée 10A du moule maître 10 est dotée d'un caractère antiadhésif, afin notamment de faciliter le démoulage ultérieur du moule d'impression.

Dans ce mode de mise en œuvre préférentiel, le moule maître 10 comprend, outre le substrat 11, une couche antiadhésive 12 disposée sur le substrat 11. La surface structurée 10A, dotée du caractère antiadhésif, appartient alors à la couche antiadhésive 12. En d'autres termes, la surface structurée 10A est constituée par la couche antiadhésive 12.

Sur la figure 1A, les motifs 20 sont formés (de préférence par gravure) dans le substrat 11, depuis l'une de ses faces principales, et la couche antiadhésive 12 qui recouvre les motifs 20 présente une épaisseur constante. Ainsi, le rapport d'aspect des motifs 20 est conservé.

La couche antiadhésive 12 est par exemple un revêtement de type trichlorofluorosilane déposé (de manière conforme) sur le substrat 11 par une technique de dépôt chimique en phase vapeur (ou CVD, pour « Chemical Vapor Deposition » en anglais).

Le moule maître 10 peut alternativement comprendre un substrat 11 dont les faces principales sont planes et une couche antiadhésive 12, d'épaisseur variable, dans laquelle les motifs 20 sont formés.

Dans une variante de mise en œuvre, non représentée par les figures, le moule maître 10 ne comprend que le substrat 11, dont une face est structurée pour former les motifs 20. En effet, le substrat 11 peut être formé d'un matériau présentant d'emblée (ou intrinsèquement) le caractère adhésif recherché, par exemple le silicium avec un angle de contact avec l'eau inférieur à 10°. Alternativement, le substrat 11 peut subir un traitement de surface lui permettant d'acquérir ce caractère adhésif. On peut citer à titre d'exemple un plasma oxygène ou un dépôt par vapeur d'hexaméthyldisilazane (HMDS).

A l'étape S2 de la figure 1B, une portion 100 seulement de la surface structurée 10A est modifiée de façon à faire perdre à cette portion 100 son caractère antiadhésif. La portion 100 contient au moins un des motifs 20 de de la surface structurée 10A. La portion restante, non modifiée, de la surface structurée 10A comprend également un ou plusieurs motifs 20.

Dans le mode de mise en œuvre préférentiel des figures 1A-1F, la modification de la portion 100 de la surface structurée 10A peut être accomplie soit en dégradant une portion de la couche antiadhésive 12, soit en retirant entièrement (c.-à-d. sur toute l'épaisseur de la couche antiadhésive 12) une portion de la couche antiadhésive 12, par exemple par gravure.

Dans le cas d'une dégradation, la couche antiadhésive 12 subsiste mais devient adhésive. La dégradation peut notamment consister en une augmentation de la rugosité de la couche antiadhésive 12 ou en une modification de l'affinité chimique. La couche antiadhésive 12 peut être dégradée par une pointe comme celle d'un microscope à force atomique ou par exposition à un faisceau d'électrons, un laser ou une solution chimique. A titre d'exemple, la couche antiadhésive 12 est dégradée (localement) par exposition à un faisceau d'électrons, à une dose de 250 µc/cm².

Dans le cas d'une gravure, le substrat 11, qui présente un caractère adhésif, est en partie exposé. La couche antiadhésive 12 peut être gravée (localement) par un plasma à base d'oxygène par exemple.

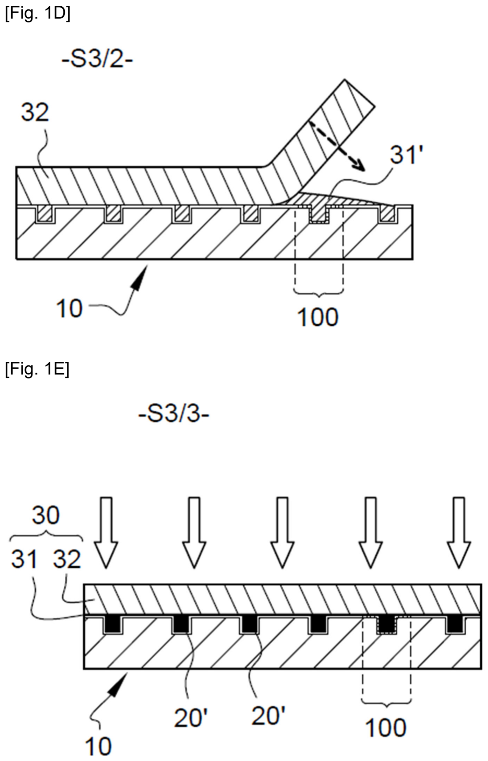

Le procédé comprend ensuite une étape S3 de formation d'un support 30 sur la surface structurée 10A du moule maître 10. Ce support 30 est ici souple et destiné à former le moule d'impression souple. Il comprend une couche d'impression 31 structurée par les motifs 20 du moule maître 10, et notamment par le ou les motifs 20 contenus dans la portion modifiée 100 de la surface structurée 10A (cf. Fig.1E). Ainsi, la couche d'impression 31 comprend des motifs (d'impression) 20' correspondants à ceux du moule maître (de même dimensions mais en négatif : ici un motif 20 en creux devient un motif 20' en saillie).

La couche d'impression 31 est formée à partir d'un matériau déformable, afin qu'elle puisse être structurée par les motifs 20. Ce matériau déformable est de préférence un matériau polymère à l'état liquide ou semi-liquide (visqueux), par exemple une résine durcissable.

Les figures 1C à 1E illustrent un premier mode de mise en œuvre de l'étape S3 de formation du support 30. Lors d'une première sous-étape S3/1 représentée par la figure 1C, une couche de résine durcissable 31' est déposée sur la surface structurée 10A. De préférence, la couche de résine durcissable 31' remplit tous les motifs 20 du moule maître 10 et forme une surépaisseur sur la surface du moule maître 10. Elle est par exemple déposée par enduction centrifuge (« spin-coating » en anglais). Puis, lors d'une deuxième sous-étape S3/2 représentée par la figure 1D, une couche de support, ici formée par un film souple 32, est mise en contact avec la couche de résine durcissable 31'. Le film souple 32 peut être laminé sur la couche de résine durcissable 31'. Enfin, la résine est durcie lors d'une troisième sous-étape S3/3 représentée par la figure 1C.

Dans un deuxième mode de mise en œuvre, l'étape S3 de formation du support 30 comprend les sous-étapes suivantes :
- le dépôt une couche de résine durcissable sur une couche de support telle qu'un film souple ;
- le pressage la couche de résine durcissable contre la surface structurée ; et
- le durcissement de la résine ;

Dans ces deux modes de mises en œuvre de l'étape S3, la couche d'impression 31 du support 30 est formée par la couche de résine durcie.

La résine peut être photo-durcissable et/ou thermo-durcissable (on parle aussi de résine photosensible ou thermosensible). Autrement dit, elle est durcie (ou réticulée) par exposition à un rayonnement électromagnétique (typiquement un rayonnement UV) et/ou un traitement thermique.

La résine durcissable peut contenir une charge inorganique, afin d'améliorer les propriétés de la couche d'impression 31, typiquement sa résistance mécanique. La résine durcie forme alors un matériau composite comprenant une matrice de polymère et une charge inorganique. La charge inorganique est par exemple sous la forme de particules.

Le film souple 32 est de préférence en un matériau polymère (seul) ou en un matériau composite. On peut citer à titre d'exemple le polydiméthylsiloxane (PDMS). Son épaisseur est avantageusement comprise entre 1 µm et 10 µm. Il confère au moule souple ses propriétés mécaniques. Ainsi, son module de Young est avantageusement inférieur à 1 GPa et/ou il est capable de subir une déformation en flexion avec un rayon de courbure inférieur ou égal à 1 m, de préférence inférieur ou égal à 5 cm.

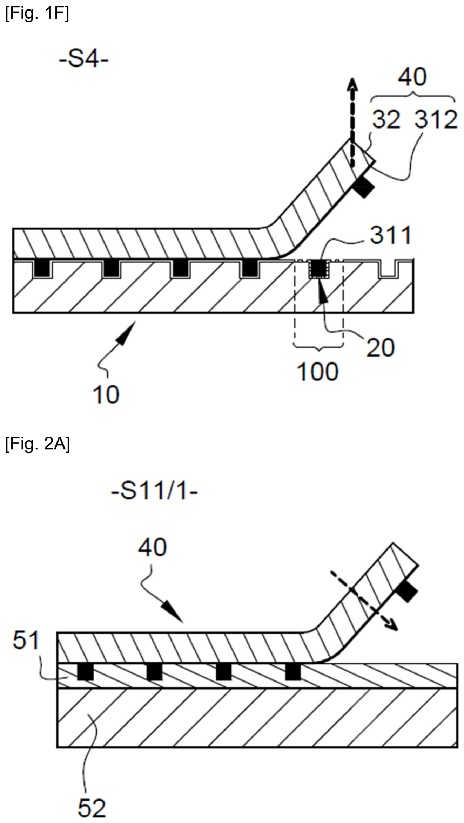

En référence à la figure 1F, le procédé de fabrication comprend une étape S4 dite de démoulage consistant à séparer le support 30 du moule maître 10 pour obtenir le moule d'impression 40. Cette séparation peut notamment être réalisée par pelage.

Une partie 311 de la couche d'impression 31 reste fixée à la portion modifiée 100 de la surface structurée 10A, rendue adhésive à l'étape S2 de la figure 1B. Le moule d'impression 40 est formé par le support 30 comprenant ici la partie restante 312 de la couche d'impression 31 et le film souple 32. Un ou plusieurs motifs 20 du moule maître 10 situés dans la portion modifiée 100 sont ainsi « bouchés » par cette partie 311 de la couche d'impression 31 et ne se retrouvent pas dans le moule d'impression 40.

Ainsi, le caractère adhésif ou antiadhésif de la surface structurée 10A, de la couche antiadhésive 12 ou du substrat 11 s'entend par rapport au matériau (éventuellement composite) de la couche d'impression 31.

Le procédé de fabrication permet ainsi de sélectionner quel(s) motif(s) 20 du moule maître 10 ne sera pas répliqué dans le moule d'impression 40. Il est donc possible, grâce à ce procédé, de réaliser à partir d'un même moule maître 10 (cf. Fig.1A) des moules d'impression ayant des distributions de motifs différentes.

Après la fabrication d'un premier moule d'impression 40, le procédé peut comprendre une étape de restauration de la surface structurée 10A dotée du caractère antiadhésif, revenant ainsi au stade de la figure 1A. La partie 311 de la couche d'impression 31 restée collée au moule maître 10 peut être éliminée simultanément.

Dans le mode de mise en œuvre préférentiel décrit en relation avec les figures 1A-1F, cette étape de restauration peut comprendre une sous-étape de retrait de la couche antiadhésive 12, de préférence par voie humide (solution d'acide peroxymonosulfurique par exemple), et une sous-étape de formation d'une nouvelle couche antiadhésive sur le substrat 11 mis à nu.

Puis, un deuxième moule d'impression peut être fabriqué en accomplissant à nouveau les étapes S2, S3 et S4 décrites ci-dessus. Le deuxième moule d'impression est différencié du premier moule d'impression en changeant la portion modifiée 100 de la surface structurée 10A dans la localisation et/ou son étendue (autrement dit en sélectionnant au moins un autre motif 20 ou en diminuant le nombre de motifs 20 dans la portion 100).

Les différents moules d'impression peuvent servir lors de la fabrication d'un même dispositif microélectronique ou pour fabriquer des dispositifs microélectroniques différents.

Dans une variante de mise en œuvre non représentée par les figures, un moule d'impression rigide est obtenu en remplaçant dans le procédé des figures 1A-1F (et plus particulièrement aux étapes des figures 1D à 1F) le film souple 32 par un substrat rigide aussi appelé poignée rigide (en tant que couche de support). Le substrat rigide est par exemple en verre, en quartz, en silicium ou en un métal. Il est mis en contact avec le moule maitre 10, ainsi que démoulé, soit de manière parallèle au plan du moule maitre 10, soit avec un angle (cela facilite le détachement). Comme précédemment, le matériau déformable formant la couche d'impression 31 du support 30 peut être déposée soit sur le moule maître 10 (puis le substrat rigide vient par-dessus), soit sur la couche de support formée ici par le substrat rigide.

Le procédé de fabrication trouve notamment des applications avantageuses dans le domaine de l'identification électronique ou celui de la sécurisation de puces électroniques, des domaines où l'on cherche à former des ensemble de motifs différents.

Les figures 2A à 2C illustrent un exemple d'utilisation du moule d'impression 40 : un procédé de lithographie par impression.

Le procédé de lithographie comprend une étape d'impression S11, au moyen du moule d'impression 40, de motifs 53 dans une couche de matériau imprimable 51 disposée sur un substrat cible 52.

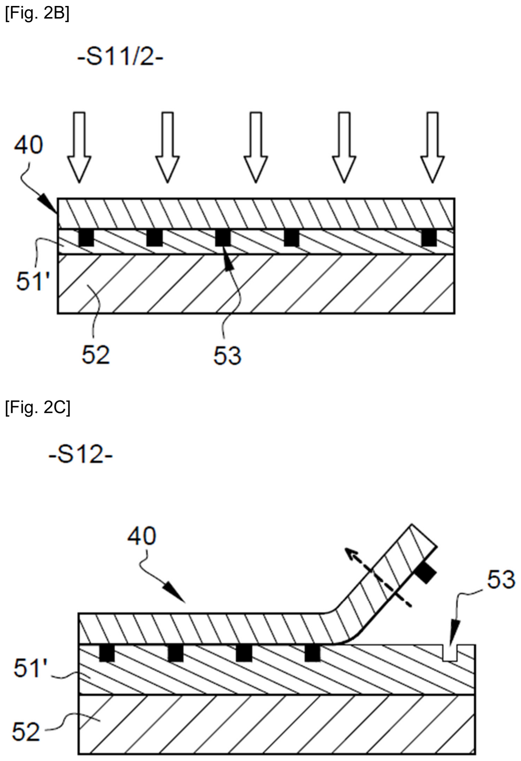

Lorsque la couche de matériau imprimable 51 est formée d'une résine durcissable (thermo-durcissable et/ou photo-durcissable), l'impression des motifs 53 peut comprendre deux sous-étapes S11/1 et S11/2 représentées par les figures 2A et 2B. En S11/1 (cf. Fig.2A), le moule d'impression 40 est pressé contre la couche de résine 51 de manière à transférer les motifs du moule d'impression 40 dans la couche de résine 51. Puis, en S11/2 (cf. Fig.2B), la résine est durcie (avec le moule d'impression 40 toujours appliqué contre la couche de résine 51).

A l'issue de l'étape d'impression S1, une couche imprimée 51', c'est-à-dire comprenant des motifs 53 correspondant à ceux du moule d'impression 40, est obtenue.

En référence à la figure 2C, le procédé de lithographie comprend ensuite une étape S12 de démoulage consistant à séparer le moule d'impression 40 de la couche imprimée 51'. Le démoulage peut notamment être réalisé par pelage dans le cas d'une moule d'impression souple.

Enfin, après le démoulage, le procédé de lithographie peut comprendre une étape de transfert des motifs 53 de la couche imprimée 51' dans le substrat cible 52, par exemple par gravure à travers la couche imprimée 51' (la couche imprimée 51' servant ainsi de masque de gravure).

## Revendications

1. Procédé de fabrication d'un moule d'impression (40), comprenant les étapes suivantes :
- fournir (S1) un moule maître (10) ayant une surface structurée (10A) dotée d'un caractère antiadhésif, la surface structurée (10A) présentant une pluralité de motifs (20) ;
- modifier (S2) une portion (100) seulement de la surface structurée (10A) de façon à faire perdre à ladite portion son caractère antiadhésif, ladite portion (100) comprenant au moins un des motifs (20) ;
- former (S3) un support (30) sur la surface structurée (10A), le support (30) comprenant une couche d'impression (31) structurée par les motifs (20) ;
- séparer (S4) le support (30) du moule maître (10) pour obtenir le moule d'impression (40), une partie (311) de la couche d'impression (31) restant fixée à la portion modifiée (100) de la surface structurée (10A).

2. Procédé selon la revendication 1, dans lequel le moule maître (10) comprend un substrat (11) et une couche antiadhésive (12) disposée sur le substrat (11) et dans lequel la surface structurée (10A) dotée du caractère antiadhésif appartient à la couche antiadhésive (12).

3. Procédé selon la revendication 2, dans lequel la portion (100) de la surface structurée (10A) est modifiée en dégradant une portion de la couche antiadhésive.

4. Procédé selon la revendication 3, dans lequel la portion de la couche antiadhésive (12) est dégradée par une pointe ou par exposition à un faisceau d'électrons, un laser ou une solution chimique.

5. Procédé selon la revendication 2, dans lequel la portion (100) de la surface structurée (10A) est modifiée en retirant entièrement une portion de la couche antiadhésive (12).

6. Procédé selon l'une quelconque des revendications 1 à 5, dans lequel la formation du support (30) sur la surface structurée (10A) comprend les sous-étapes suivantes :
- déposer (S3/1) une couche de résine durcissable (31') sur la surface structurée (10A) ;
- mettre en contact (S3/2) une couche de support avec la couche de résine durcissable (31') ; et
- durcir (S3/3) la résine ;
la couche d'impression (31) du support (30) étant formée par la couche de résine durcie.

7. Procédé selon l'une quelconque des revendications 1 à 5, dans lequel la formation du support (30) sur la surface structurée (10A) comprend les sous-étapes suivantes :
- déposer une couche de résine durcissable sur une couche de support ;
- presser la couche de résine durcissable contre la surface structurée ; et
- durcir la résine ;
la couche d'impression du support étant formée par la couche de résine durcie.

8. Procédé selon l'une des revendications 6 et 7, dans lequel la couche de support est un film souple (32) ou un substrat rigide.

9. Procédé selon l'une quelconque des revendications 1 à 8, comprenant en outre, après l'étape (S4) de séparation du support (30), une étape de restauration de la surface structurée (10A) dotée du caractère antiadhésif.
